Europäisches Patentamt

European Patent Office

Office européen des brevets

(11) Publication number: **0 118 336**
**B1**

# EUROPEAN PATENT SPECIFICATION

(45) Date of publication of patent specification: **20.04.88**

(51) Int. Cl.⁴: **H 01 L 27/06**

(21) Application number: **84400220.4**

(22) Date of filing: **01.02.84**

(54) **High voltage MOS/bipolar power transistor apparatus.**

(30) Priority: **03.02.83 US 463432**

(43) Date of publication of application:
**12.09.84 Bulletin 84/37**

(45) Publication of the grant of the patent:
**20.04.88 Bulletin 88/16**

(84) Designated Contracting States:
**DE FR GB IT NL**

(56) References cited:
**EP-A-0 047 392**
**AT-B- 340 481**
**DE-A-1 805 173**

(73) Proprietor: **FAIRCHILD CAMERA &
INSTRUMENT CORPORATION
464 Ellis Street
Mountain View California 94042 (US)**

(72) Inventor: **Hu, Chenming
2250 Redwood Road
Hercules California 94547 (US)**

(74) Representative: **Chareyron, Lucien et al
Schlumberger Limited Service Brevets c/o Giers
12, place des Etats Unis B.P. 121
F-92124 Montrouge Cédex (FR)**

Courier Press, Leamington Spa, England.

## Description

The present invention relates to power transistor apparatus in general and in particular, to monolithic MOS/Bipolar power transistor structures suitable for high voltage (400v—2000v) applications.

Ideally, power transistors should have insulated-gate drive, i.e. high current gain, be free of second breakdown, have low on-state resistance, high current densities and no commutation time limit, be fast switching, have no (or extremely high) dv/dt limits and extremely high di/dt limits, be easily adapted to packages for high current or double-side-cooling and, when incorporated in a monolithic integrated circuit, have optimum utilization of the integrated circuit area.

Referring to the drawing and Figs. 1—7 enclosed herewith, prior known MOS-gated power transistor apparatus which are deficient in one or more of the above described ideal characteristics include the MOS-Darlington transistor (Figs. 1 and 2), the parallel MOS-bipolar transistor (Figs. 3 and 4), the MOSFET-gated thyristor (Figs. 5 and 6) and the Cascode transistor (Fig. 7).

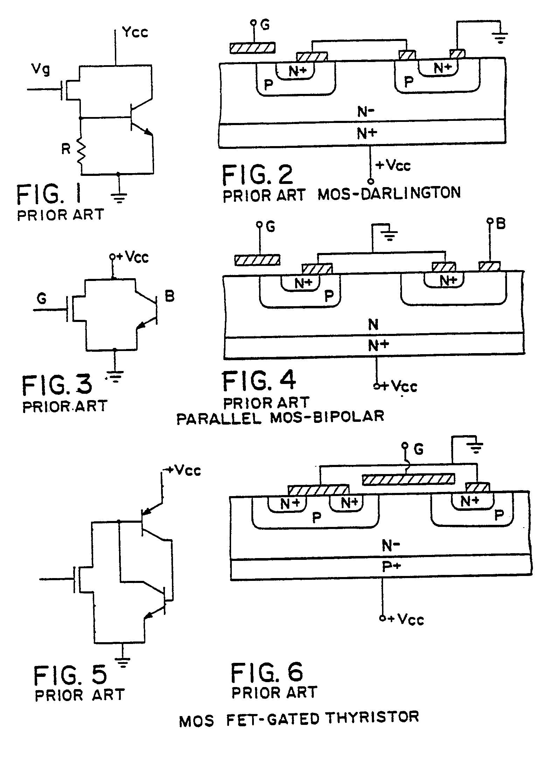

Referring to Figs. 1 and 2, the MOSFET and bipolar transistor devices shown therein are typically fabricated in physically separated cells. With MOSFET cells lumped into separate portions on the integrated circuit, the MOSFETS do not benefit from conductivity modulation. This results in a device having a characteristic high on-resistance ($R_{on}$) and low current densities. Moreover, the devices require many metal contacts, interconnections and diffused resistors which occupy large areas, particularly, if the MOSFET and bipolar cells are intermixed. For these reasons the use of large current packages is impractical.

Referring to Figs. 3 and 4, the parallel MOS-bipolar power transistor apparatus shown therein requires a four terminal package, and separate MOSFET and bipolar transistor drive circuits. The apparatus is subject to second breakdown unless complicated drive circuitry is used to turn off the base B of the NPN transistor before the gate G of the MOSFET. Moreover, the separation of the MOSFET and the bipolar cells, metal contacts and interconnections result in an inefficient use of the available area of an integrated circuit device utilizing the parallel MOS-bipolar technology.

Referring to Figs. 5 and 6, the MOSFET-gated thyristor shown therein is deficient in that it cannot be turned off by its gate G, but needs a current reversal to terminate its operation. It has a long commutation time $t_q$ limit as does other thyristors. Moreover, its MOSFET-cell to thyristor-cell ratio of three-to-one results in an inefficient use of the available area for current conduction.

While the thyristor of Figs. 5 and 6 and the apparatus of the present invention, as will be further described below, both use N material on $P^+$ substrate and rely on hole injection at the bottom PN junction for on-state operation, the prior known MOSFET-gated thyristor incorporates "thyristor cells" with floating P regions such that the positive feedback between the NPN and PNP transistors therein achieves latchup. This automatically precludes the possibility of turning off the thyristor by using its gate.

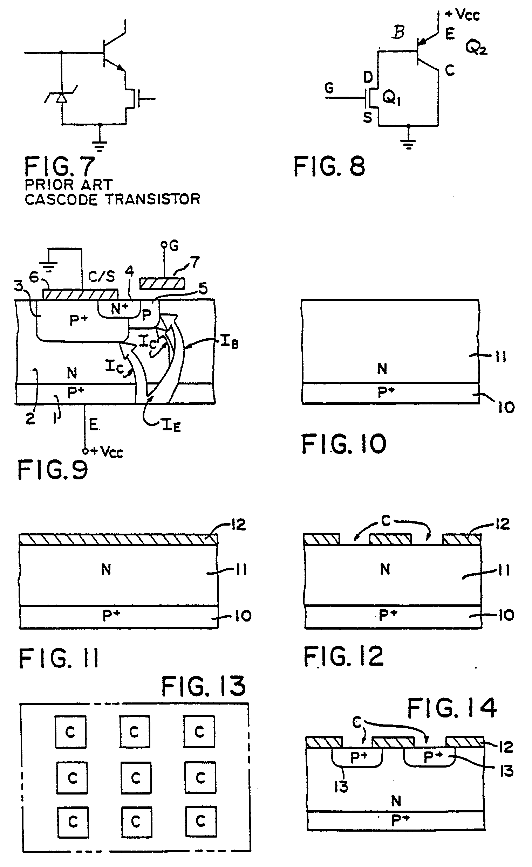

Referring to Fig. 7, the cascoded transistor apparatus shown therein requires separate bipolar and MOS drive circuitry and in general, is very difficult to embody in a monolithic integrated circuit, although, it does not suffer from second breakdown and can be turned off very rapidly.

Devices of the type shown in Figs. 1, 2 and 7 are discussed in Record of IEEE Power Electronics Specialists Conference, June 1982, pp. 371—377. A Device of the type shown in Figs. 3 and 4 is discussed in Technical Digest of IEEE International Electron Devices Meeting, December 1981, pp. 263—266. A device of the type shown in Figs. 5 and 6 is discussed in Technical Digest of IEEE International Electron Device Meeting, December 1980, pp. 79—82.

Summary of the invention

A general object of the present invention is to provide an improved monolithic MOS/bipolar power transistor structure, the MOSFET and the bipolar transistor being connected as recited in the precharacterizing portions of claim 1. Such an arrangement is already known from EP—A—0047392.

The above and other objects features and advantages of the present invention will become apparent from the following detailed description of the invention in which:

Figs. 1—7 are equivalent discrete and integrated circuits of prior art MOS-gated power transistor apparatus described above.

Fig. 8 is the discrete embodiment of the MOS/Bipolar power transistor of the prior art (EP—A—0047392).

Fig. 9 is the equivalent monolithic embodiment of an apparatus according to the present invention.

Figs. 10—25 are partial cross sectional and plan views showing the fabrication steps of an apparatus according to the present invention.

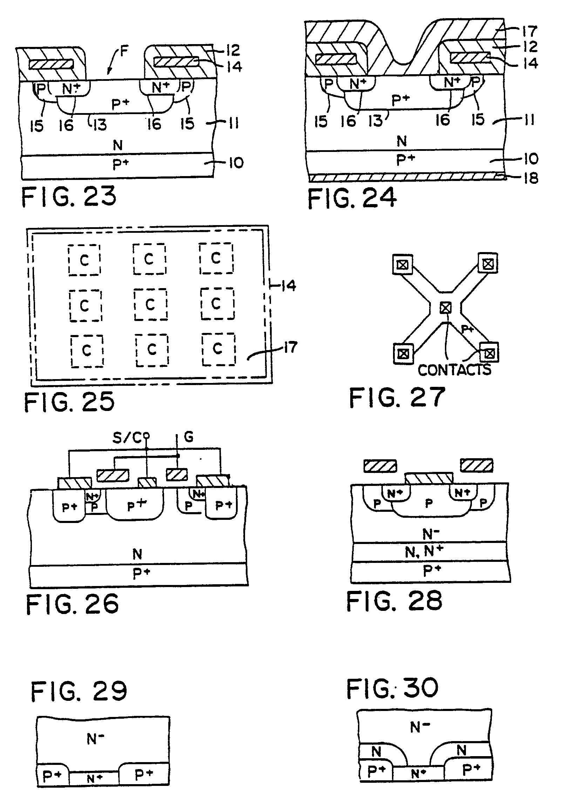

Figs. 26 and 27 are partial cross sectional and plan views of another alternative embodiment of the present invention.

Fig. 28 is a partial cross sectional view of still another alternative embodiment of the present invention.

Figs. 29 and 30 are partial cross sectional views of a reverse conducting transistor embodiment according to the present invention.

Referring to Figs. 8 and 9, there is provided a MOS device $Q_1$ having a gate G, a drain D and a source S. The drain D of the Device $Q_1$ is coupled to a base B of a PNP transistor $Q_2$. The emitter E of $Q_2$ is coupled to a source of positive potential $V_{cc}$. The collector C of $Q_2$ and the source of $Q_1$ are coupled to a source of common potential designated by a ground symbol.

In the monolithic embodiment of the present invention as shown in Fig. 9, there is provided a substrate 1 comprising a semiconductor material having a P+ type conductivity. Disposed on substrate 1 there is provided a first layer 2 of semiconductor material having an N type conductivity. Disposed in the layer 2, there is provided a second region 3 of semiconductor material comprising a P+ type conductivity. Disposed in the region 3, there is provided a third region 4 of semiconductor material comprising an N+ type conductivity. Located between the layer 2 and region 4 there is provided a region 5 of semiconductor material comprising a P type conductivity. Disposed on the regions 3 and 4, there is provided a metal contact 6. Over the regions 4, 5 and a portion of the layer 2 and insulated therefrom there is provided a gate member 7.

As will be apparent from the following description, the MOS device Q1 is an N channel device comprising the regions 4, 5 and layer 2. The vertical PNP substrate-emitter transistor Q2 comprises the PNP layers 1, 2 and 3.

In the above description of Figs. 8 and 9 of the present invention, a single cell is described. In practice, however, hundreds and even thousands of cells of the type described will be embodied in an integrated circuit using conventional wafer fabrication techniques as will now be described with respective Figs. 10—22.

Referring to Figs. 10—22, there is shown partial cross sections and plan views of a monolithic device embodying a plurality of the cells described above with respect to Figs. 8 and 9.

Typically, the fabrication of the structure of Figs. 8 and 9 is started with a layer of P+ semiconductor material 10. On the top of the layer 10, there is grown an epitaxial layer of N type semiconductor material 11 (Fig. 10). On top of the layer 11 there is deposited a layer of masking material 12, such as silicon dioxide (Fig. 11). After the deposition of the silicon dioxide layer 12, a mask is used for removing the polysilicon and silicon dioxide material to form holes therein designated C (Fig. 12).

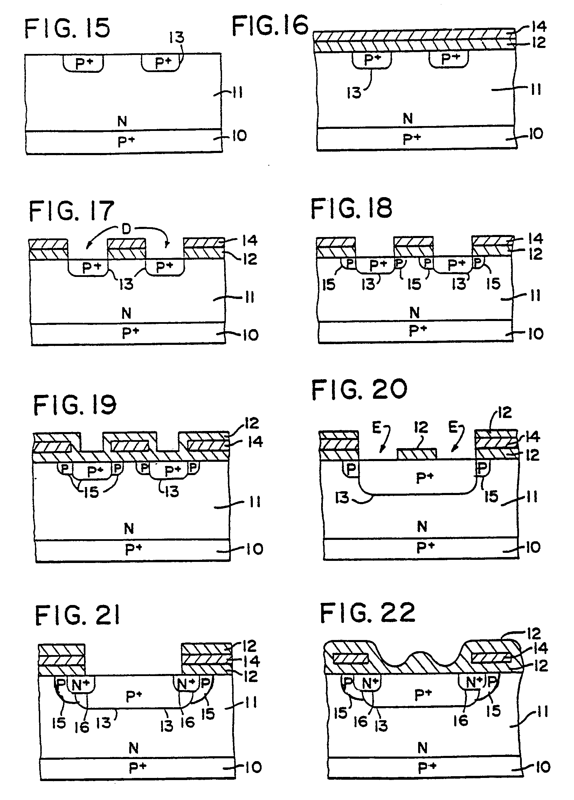

After the holes C are formed, the assembly appears from the top as a layer of silicon dioxide comprising a plurality of holes C (Fig. 13). Thereafter, a relatively deep deposition 13 of P+ type semiconductor material is made through each of the holes C (Fig. 14). After the P+ depositions 13 are completed, the silicon dioxide layer 12 is removed (Fig. 15). On top of the layers 11 and 13 there are deposited a new layer of silicon dioxide 12 and a layer 14 of conductive material such as polysilicon (Fig. 16). Another mask is used for removing the polysilicon and silicon dioxide material to form a new hole D above each of the P+ layers 13 (Fig. 17), and the holes D being slightly larger than the holes C in Fig. 13. A deposition of P type material 15 is made through the new holes D (Fig. 18). After the depositions 15 are completed, the polysilicon layer 14 and the depositions 13 and 15 are coated with a layer of the insulating material 12. (Fig. 19). After the coating of the layer 12 is completed, a mask is again used for forming a pair of holes E above each of the P+ and P layers 13 and 15 leaving there between a portion of the oxidized layer 12 (Fig. 20). After the holes E are formed, a deposition of N+ type semiconductor material 16 is made through the holes E and into the P+ layer 13 and the P layer 15 (Fig. 21). After the layer 16 is deposited, the assembly is again coated with a layer of insulating material 12 (Fig. 22). After the deposition of the layer 12 is completed, a mask is again used for forming a hole F through the layer 12 which extends from over a portion of one N+ layer 16 to over a portion of an adjacent N+ layer 16 (Fig. 23). After the hole F is formed, the top and bottom of the assembly is coated with a layer of conductive material 17 and 18, such as aluminum, for forming the emitter and collector/source contacts respectively (Fig. 24). A top view of the assembly as fabricated is shown in Fig. 25.

Referring to Fig. 25, it may be noted that the device is preferably formed with the polysilicon layer 14 extending beyond conductive layer 17. By extending the polysilicon layer 14 beyond the aluminum layer 17, means are provided for attaching the gates of all of the devices to a source of external control signals. Similarly, the front and the back layers of conductive materials 17 and 18 are readily available for connecting the emitter to a source of positive potential and the collector/source to a common potential such as ground.

Referring again to Fig. 9, in operation, in the off-state, high voltage, e.g. 400—2000 volts, is sustained by the N-epitaxial or bulk material 11, as in conventional VDMOS. In the on-state, with the MOSFET on, the main device is a PNP transistor having a wide N base. The base (electron) current $I_B$ is supplied through the MOSFET. The MOSFET current can be large and provides a fast path for the initial current $I_E$, as well as a large base current $I_B$ for rapid turn-on of the bipolar transistor. The injection of holes from the P+ substrate 1 when the MOSFET is turned on, results in conductivity modulation in the N base layer 2 which insures a low on-resistance $R_{ON}$ for the MOSFET and therefore the large $I_B$ in the on-state. The large $I_B$ keeps the bipolar transistor close to saturation and keeps the forward voltage drop $V_{CE}$ low. However, base current $I_B$ is self-regulated. That is, the transistor cannot be saturated such that P-collector is forward biased with respect to the N-base. If this were not so, the MOSFET drain N− would be more negative than the source N+ and $I_B$ would become negative. The bipolar transistor will hence be automatically biased to $V_{CE}$, where $V_{CE}$ is approximately equal to $0.7v + R_{CH}I/(1+ß)$, where $R_{CH}$ is the channel resistance of the MOSFET and $ß$ is the current gain of the bipolar transistor. $R_{CH}$ can be very small even in very high voltage devices. Since the transistor is never in saturation, its turn-off speed is optimized.

Because $I_B$ is self-regulated by the local $R_{CH}$, which has positive temperature coefficient, phenomena such as hot spots, forward-biased second breakdown, and current hopping in parallel devices are eliminated. The wide base structure also eliminates the problem associated with the crowding of current at the edges of emitter fingers; since there are no emitter fingers, and achieves better current density than conventional bipolar transistors.

At turn-off, when the MOSFET is turned off, the bipolar transistor undergoes an open-base turn-off. This need not be a slow process, since the electrons in the base of a low $\beta$ transistor can be dissipated through recombination or through injection into the emitter as quickly as can be achieved by the reverse base current in a high $\beta$ transistor. In fact, the rate of removal of storage charge is equal to $I_{BR}+I_C/\beta$, where $I_{BR}$ is the reverse base current. In a low $\beta$ transistor, the second term can dominate and an open base ($I_{BR}=0$) turn-off can still be fast. For example, an open base turn-off in a transistor with $\beta=5$ is equivalent to having $I_{BR}=I_C/5$ in a high $\beta$ transistor in terms of the rate of charge removal. The bipolar transistor, therefore, should have a relatively low $\beta$. This may be achieved through lifetime control or through the use of emitter shorts, as described above with respect to Figs. 28 and 29. It is estimated that the storage time and the fall time together will be lower than 2 microseconds.

Because the base is open, there is no current crowding under emitter fingers and no reverse-base second breakdown. Additionally, there is no commutation time $t_q$ requirement, unlike the case of thyristors. Indeed, the above discussion of turn-off clearly states that the device voltage need not be reversed during or after turn-off.

While the present invention uses an N layer on a $P^+$ substrate and relys on hole injection at the bottom $P^+/N$ junction for on-state operation as is utilized in the MOSFET-gated thyristor of Figs. 5 and 6, the apparatus of the present invention not only eliminats the "thyristor cell" with floating P regions, but also takes great care in shorting out the base resistance of the parasitic NPN transistors in the MOSFET cells. Without these special precautions, the parasitic transistor could cause latchup and prevent gate turn-off. A sufficient condition for preventing latchup is to make $R_B \cdot I_C'<0.6v$. Where $R_B$ is the base resistance of the parasitic NPN transistor and $I_C'$ is the hole current collected by the P (not the $P^+$) region.

Even though the apparatus of the present invention is not a thyristor, it can be turned off by current reversal (line or circuit commutation) with the MOSFET in the on-state. In this mode, the turn-off of one device may be synchronized with a turn-on with another device without conduction overlay or discontinuity.

Referring to Figs. 26 and 27, there is shown another embodiment of the present invention in which both $R_B$ and $I_C'$ are reduced. In this embodiment the deep $P^+$ regions make additional connections with a P region in an attempt to reduce the $R_B$. They also increase $R_{CH}$ of the MOSFET and increase the on-state voltage drop.

Referring to Fig. 28, by adding an additional N or N+ layer between the N− and P+ layers, punch-through can be avoided and more voltage may be sustained for the same N− layer thickness. This N or N+ layer also reduces the transistor $\beta$ by increasing the base Gummel number, which may be desirable for achieving short turn-off time and higher open-base breakdown voltage of the PNP transistor.

Referring to Figs. 29 and 30, for inverter applications, reverse conducting switches are desirable. The apparatus according to the present invention can be made to conduct in the reverse direction by using structures as shown in Figs. 28 and 29. The "emitter shorts" shown therein will reduce the $\beta$ of the bipolar transistor and may help with the turnoff speed though increasing the on-state voltage drop. If the effect on $\beta$ is to be minimized, these "shorts" may be placed near the edge of the chip and under the contact pads.

**Claims**

1. A high voltage MOS/BIPOLAR power transistor structure comprising in a monolithic structure: a field effect transistor (Q1) having a source, a drain and a gate; a bipolar transistor (Q2) having a collector, an emitter and a base, means for coupling said source and said collector to a common potential; and means for coupling said drain to said base; characterized by comprising: a semiconductor substrate (1) of first conductivity type for providing said emitter; a first layer (2) of opposite conductivity type semiconductor material disposed on the substrate for providing both said base and said drain, said first layer (2) having an upper surface; a first region (3) of first conductivity type disposed in said first layer (2) adjacent the upper surface for providing said collector; a second region (5) of first conductivity type having a lower impurity concentration than the first region (3) disposed in said first layer (2) adjacent the upper surface and contiguous to the first region (3) for providing a channel of the field effect transistor (Q1); a third region (4) of opposite conductivity type disposed in portions of both the first and second regions (3, 5) adjacent the upper surface for providing said source; an insulating layer disposed on the upper surface over at least the second region; and a first electrode (7) disposed on the insulating layer over at least the second region for providing a gate electrode for the field effect transistor.

2. A structure according to Claim 1 characterized in that said means for coupling said source and said collector to a common potential comprises a second electrode (6) disposed to contact both the first and the third regions (3, 4).

3. A structure according to Claim 1 or 2 characterized in that said source (4), said channel (5) and said base (2) form a parasitic bipolar transistor having a collector current with the channel (5) functioning as a parasitic base and the base (2) functioning as a parasitic collector, and in that the resistance of said parasitic base is less than 0,6 volts divided by the collector current.

4. A structure according to any one of Claim 1 to 3 characterized in that said first type of conductivity is p-type conductivity and said second type of conductivity is n-type conductivity.

5. A structure according to Claim 4 characterized in that said P type conductivity in said substrate (1) and said first region (3) of said first layer is p+ type conductivity and said n type conductivity in said third region (4) is n+ type conductivity.

6. A structure according to any one of Claims 1 to 4 characterized by comprising a third electrode (18) disposed to contact the entire lower surface of said substrate (1) for providing an emitter electrode.

**Patentansprüche**

1. Eine Hochspannungs-MOS/BIPOLAR-Leistungstransistor-Struktur, umfassend in einer monolithischen Struktur: einen Feldeffekttransistor (Q1) mit einer Source, einem Drain und einem Gate; einen bipolaren Transistor (Q2) mit einem Kollektor, einem Emitter und einer Basis, Mittel für das Koppeln der Source und des Kollektors an ein gemeinsames Potential; und Mittel für das Koppeln des Drains mit der Basis, gekennzeichnet durch:
ein Halbleitersubstrat (1) eines ersten Leitfähigkeitstyps für das Vorsehen des Emitters,
eine erste Schicht (2) von Halbleitermaterial entgegengesetzten Leitfähigkeitstyps, angeordnet auf dem Substrat für das Vorsehen sowohl der Basis als auch des Drains, wobei die erste Schicht (2) eine obere Oberfläche aufweist;
eines ersten Bereichs (3) des ersten Leitfähigkeitstyps, angeordnet auf der ersten Schicht (2) nahe der oberen Oberfläche für das Vorsehen des Kollektors;
einen zweiten Bereich (5) des ersten Leitfähigkeitstyps mit einer niedrigeren Störstellenkonzentration als der erste Bereich (3), ausgebildet in der ersten Schicht (2) nahe der oberen Oberfläche und anschließend an den ersten Bereich (3) für das Vorsehen eines Kanals des Feldeffekttransistors (Q1);
einen dritten Bereich (4) entgegengesetzten Leitfähigkeitstyps, ausgebildet in Abschnitten sowohl des ersten als auch des zweiten Bereichs (3, 5) nahe der oberen Oberfläche für das Vorsehen der Source;
eine isolierende Schicht, ausgebildet auf der oberen Oberfläche über zumindest dem zweiten Bereich und
eine erste Elektrode (7), ausgebildet auf der Isolierschicht über zumindest dem zweiten Bereich für das Vorsehen einer Gate-Elektrode für den Feldeffekttransistor.

2. Eine Struktur nach Anspruch 1, dadurch gekennzeichnet, daß die Mittel für das Koppeln der Source und des Kollektors an ein gemeinsames Potential eine zweite Elektrode (6) umfassen, ausgebildet zum Kontaktieren sowohl der ersten als auch der dritten Region (3, 4).

3. Eine Struktur nach Anspruch 1 oder 2, dadurch gekennzeichnet, daß die Source (4), der Kanal (5) und die Basis (2) einen parasitären bipolaren Transistor bilden mit einem Kollektor-Strom, bei dem der Kanal (5) als eine parasitische Basis und die Basis (2) als ein parasitischer Kollektor funktionieren, und daß der Widerstand der parasitischen Basis kleiner ist als 0,6 Volt, dividiert durch den Kollektor-Strom.

4. Eine Struktur nach einem der Ansprüche 1 bis 3, dadurch gekennzeichnet, daß der erste Leitfähigkeitstyp p-Leitfähigkeit ist und der zweite Leitfähigkeitstyp n-Leitfähigkeit ist.

5. Eine Struktur nach Anspruch 4, dadurch gekennzeichnet, daß die p-Leitfähigkeit in dem Substrat (1) und dem ersten Bereich (3) der ersten Schicht p+-Leitfähigkeit ist und daß die n-Leitfähigkeit in dem dritten Bereich (4) n+-Leitfähigkeit ist.

6. Eine Struktur nach einem der Ansprüche 1 bis 4, gekennzeichnet durch eine dritte Elektrode (18), ausgebildet in Kontakt mit der gesamten unteren Oberfläche des Substrats (1) für das Vorsehen einer Emitter-Elektrode.

**Revendications**

1. Structure de transistor de puissance MOS/bipolaire à haute tension comprenant dans une structure monolithique: un transistor à effet de champ (Q1) ayant une source, un drain et une grille; un transistor bipolaire (Q2) ayant un collecteur, un émetteur et une base; des moyens pour connecter ladite source et ledit collecteur à un potentiel commun; et des moyens pour relier ledit drain à ladite base; caractérisé en ce qu'elle comprend:
un substrat semi-conducteur (1) d'un premier type de conductivité pour former ledit émetteur;
une première couche (2) de matériau semi-conducteur de type de conductivité opposé, disposée sur le substrat pour former à la fois ladite base et ledit drain, ladite première couche (2) ayant une surface supérieure;
une première région (3) du premier type de conductivité, disposée dans ladite première couche (2) de façon adjacente à la surface supérieure pour former ledit collecteur;
une deuxième région (5) du premier type de conductivité ayant une concentration en impuretés inférieure à celle de la première région (3), la deuxième région étant disposée dans ladite première couche (2) de façon adjacente à la surface supérieure et contiguë à la première région (3) pour former un canal du transistor à effet de champ (Q1);
une troisième région (4) du type de conductivité opposé, disposée dans des parties des première et deuxième régions (3, 5) de façon adjacente à la surface supérieure pour former ladite source;
une couche isolante disposée sur la surface supérieure au-dessus d'au moins la deuxième région; et
une première électrode (7) disposée sur la couche isolante au-dessus d'au moins la deuxième région pour former une électrode de grille pour le transistor à effet de champ.

2. Structure selon la revendication 1, caractérisée en ce que lesdits moyens pour connecter ladite source et ledit collecteur à un potentiel commun comprennent une deuxième électrode (6) disposée au contact à la fois des première et troisième régions (3, 4).

3. Structure selon la revendication 1 ou 2, caractérisée en ce que ladite source (4), ledit canal (5) et ladite base (2) forment un transistor bipolaire parasitaire ayant un courant de collecteur, le canal (5) fonctionnant commant base parasitaire et la base (2) fonctionnant comme collecteur parasitaire, et en ce que la résistance de ladite base parasitaire est inférieure à 0,6 volt divisé par le courant de collecteur.

4. Structure selon l'une des revendications 1 à 3, caractérisée en ce que ledit premier type de conductivité est le type p et ledit deuxième type de conductivité est le type n.

5. Structure selon la revendication 4, caractérisée en ce que la conductivité de type p dudit substrat (1) et de ladite première région (3) de la première couche est une conductivité de type p+ et la conductivité de type n de ladite troisième région est une conductivité de type n+.

6. Structure selon l'une des revendications 1 à 4, caractérisée en ce qu'elle comprend une troisième électrode (18) disposée au contact de toute la surface inférieure dudit substrat (1) pour former une électrode d'émetteur.

0 118 336

FIG. 1
PRIOR ART

FIG. 2
PRIOR ART  MOS-DARLINGTON

FIG. 3
PRIOR ART

FIG. 4
PRIOR ART
PARALLEL MOS-BIPOLAR

FIG. 5
PRIOR ART

FIG. 6
PRIOR ART

MOS FET-GATED THYRISTOR

1

FIG. 7
PRIOR ART
CASCODE TRANSISTOR

FIG. 8

FIG. 9

FIG. IO

FIG. II

FIG. I2

FIG. I3

FIG. I4

2

FIG. 15

FIG. 16

FIG. 17

FIG. 18

FIG. 19

FIG. 20

FIG. 21

FIG. 22

FIG. 23

FIG. 24

FIG. 25

FIG. 27

CONTACTS

FIG. 26

S/C    G

FIG. 28

FIG. 29

FIG. 30

4